Europäisches Patentamt

European Patent Office

Office européen des brevets

(19)

(11) Publication number: **0 311 434**
**A2**

# EUROPEAN PATENT APPLICATION

(12)

(21) Application number: **88309392.4**

(22) Date of filing: **07.10.88**

(51) Int. Cl.⁴: **H 01 L 23/50**

(30) Priority: **09.10.87 GB 8723736**
**03.05.88 GB 8810389**

(43) Date of publication of application:
**12.04.89 Bulletin 89/15**

(84) Designated Contracting States:
**BE CH DE FR GB IT LI LU NL**

(71) Applicant: **THE DE LA RUE COMPANY PLC**
**De La Rue House 3/5 Burlington Gardens**
**GB-London W1A 1DL (GB)**

(72) Inventor: **Etherington, Harry James Charles**
**"Tallarna" Grosvenor Road**
**Godalming Surrey GU7 1PA (GB)**

**Newman, Roger Keith**
**Meadow Croft Hoe Road**
**Bishops Waltham Southampton Hampshire (GB)**

(74) Representative: **Skone James, Robert Edmund et al**
**GILL JENNINGS & EVERY 53-64 Chancery Lane**
**London WC2A 1HN (GB)**

(54) **Integrated circuit card.**

(57) An integrated circuit card comprises a planar body formed by laminated plastics layers (1-7) within which is mounted an IC element (11). The card includes two star-shaped stress reduction members (15,16) which locally stiffen the card body adjacent the IC element, the stress reduction members being positioned between the IC element (11) and adjacent surfaces of the body. The stress reduction members reduce stresses to which the IC element is subjected in use.

*Fig.2.*

EP 0 311 434 A2

**Description**

## INTEGRATED CIRCUIT CARD

The invention relates to integrated circuit cards comprising a planar body within which is mounted an IC element. Such integrated circuit (IC) cards are hereinafter referred to as of the kind described.

IC cards of the kind described typically comprise a laminated structure within which the IC element is secured during the lamination process. There is considerable difficulty in embedding IC elements within laminated, plastics cards when such cards have to conform to recognised international standards - particularly for thickness. Such international standards have been set up for IC cards used for financial transactions or for identification purposes.

Furthermore, the IC elements within the IC cards have to withstand substantial mechanical stresses during manufacture and during normal use while the problem is made substantially more difficult by the relatively large area and thickness of silicon used in the IC element for such cards and the brittle nature of the silicon.

Various methods have been proposed for relieving stress within the IC element but these lead to the card itself being subjected to undue stresses during use.

In accordance with the present invention, an integrated circuit card of the kind described further comprises a stress reduction member positioned between the IC element and one surface of the body, the stress reduction member stiffening the card body only adjacent the IC element so as to reduce stresses to which the IC element is subjected.

We have designed a stress reduction member, which for the IC element reduces the stresses arising from card manufacture and card use, which for the card itself avoids undue stresses arising from (a) these circumstances and (b) the discontinuities introduced within the card body by the stress reduction member.

The stress reduction member does not stiffen the card body significantly outside the region adjacent the IC element.

The stiffening effect has advantage both during manufacture and subsequent use.

In the preferred arrangement, the stress reduction member comprises at least one protruding portion extending laterally into the card body. This form of stress reduction member provides a graduation in stiffness from the centre of the member to the end of the protruding portion in order to avoid creating undue bending stresses within the IC element and undue stresses within the card body at the transition boundary between the card body and the stress reduction member.

In another arrangement, the stress reduction member, with or without protruding portions, could taper from its centre to its boundary to provide gradually increasing stiffness towards the centre.

Stiffness can be measured by considering the degree to which an element (plastics card body or stress reduction member) deflects under a given load and support conditions.

In one example a single stress reduction member is provided. However in the preferred arrangement two such members are provided on opposite sides of the IC element. Preferably, in this case, where each has at least one protruding portion, the or each protruding portion of one member is angularly offset from each protruding portion of the other member.

Preferably, the central portion has an area which covers at least the IC element. This optimises the action of the stress reduction member.

Preferably, the or each stress reduction member has an odd number of protruding portions. This avoids the generation of an "axis of stress" in the card extending through the centre of the member.

In the preferred arrangement, the or each stress reduction member has a star shape. We have found that this provides a gradually increasing stiffness from the outer boundaries of the tips of the star to the central portion of the star and thus avoids abrupt changes in stress conditions of the card body.

The or each stress reduction member may comprise a metal, such as stainless steel or brass, although other materials could also be used. A particular advantage of constructing the stress reduction member from a heat conductor, such as a metal, is that the member can act as a heat sink for the IC element.

Typically, the or each stress reduction member will have a "grain" structure, eg. a rolled metal. In this case it is preferred that the grain extends transverse to a long dimension of the card body.

Typically, the card body is produced in a conventional laminating process. In this case the card laminations have to accommodate the changes in shape associated with the stress reduction member(s), the IC element, and any carrier for the IC element. Preferably, the inner (core) layers are kept to a minimum number consistent with accommodating the shapes of these items. Each core layer preferably has a thickness substantially equal to the item whose shape it accommodates.

It is particularly convenient to construct a module formed by a flexible planar substrate carrying the IC element and a pair of stress reduction members on either side of the IC element. This module is then laminated into a card.

Preferably, the or each stress reduction member is not bonded to the card body. This allows relative movement to take place between the member and the body during flexure. In addition the member(s) are preferably not rigidly bonded to a carrier for the IC element. For example bonding by means of double sided adhesive tape is possible if the bonding allows flexure to take place.

In general the IC element will be provided on a carrier which further comprises means to enable contacts on the IC element to be connected with an IC card terminal via IC card contacts. In these circumstances, when a single stress reduction member is provided, then this is preferably on the opposite side of the IC element to the IC card contacts.

An example of an integrated circuit card in accordance with the present invention will now be described with reference to the accompanying drawings, in which:-

Figure I is an exploded view of the card;

Figure 2 is a perspective view of the IC module;

Figure 3 is a plan of the conductor pattern provided on the carrier element of the IC module; and,

Figure 4 is an enlarged cross-section through part of the card.

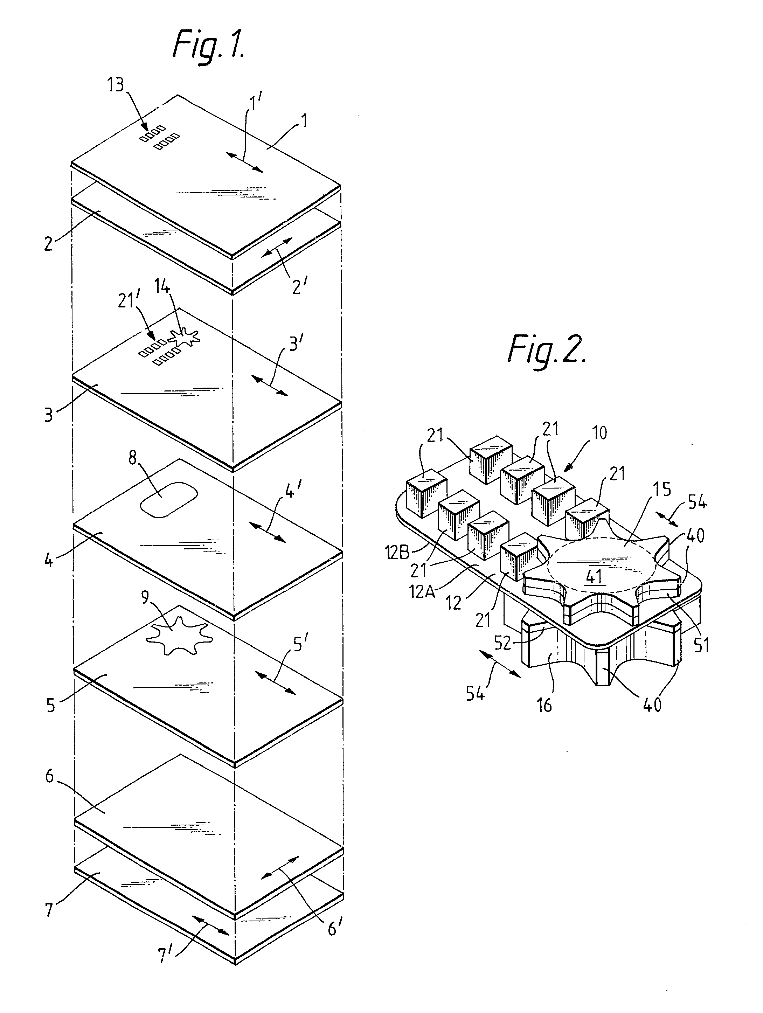

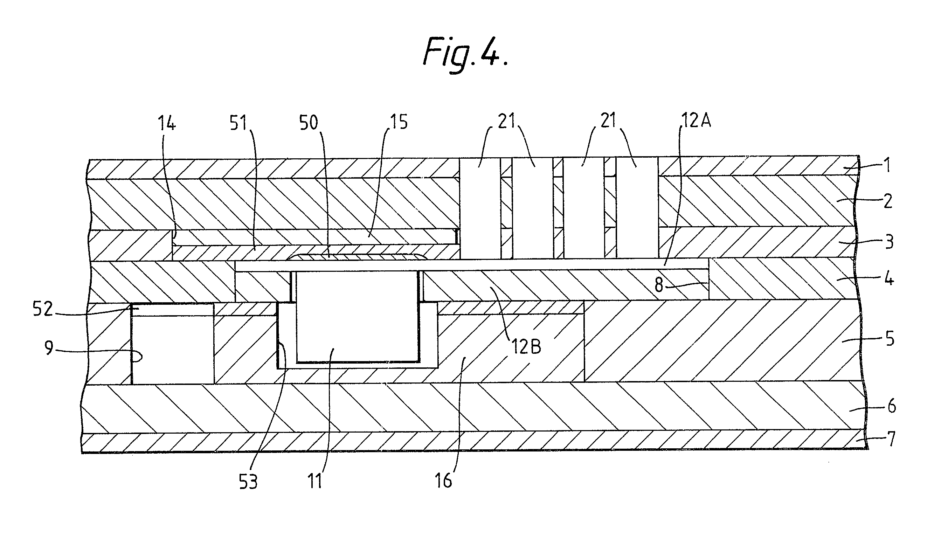

The integrated circuit card comprises a laminate, as shown in Figures 1 and 4, having a number of plastics layers 1-7. The plastics layers 1-7 typically comprise PVC, PVCA or similar materials. The thickness of these layers is set out in Table 1 below.

TABLE 1

| Layer Number | Pre-lamination Thickness($\mu$m) |
|---|---|
| (1) | 60 |
| (2) | 150 |
| (3) | 120 |
| (4) | 120 |
| (5) | 250 |
| (6) | 150 |
| (7) | 60 |

After lamination, the total thickness of the card will reduce to about 780$\mu$m. Each layer has a grain due to the method of manufacture in which the sheets are rolled and calendered causing some alignment of the molecular structure. Consequently, each layer is "stiffer" across the grain than along the grain. The grain direction of each layer is indicated in Figure 1 by arrows 1' - 7' respectively and it will be seen that the grain direction of layers 2 and 6 is transverse to that of the remaining layers. These layers 2,6 are typically opaque and carry printing on their outwardly facing surfaces. Due to their thickness relative to the other layers and their positions towards the outside of the card there is a significant risk of cracking of these two layers when the card is bent in its short dimension, if the grain of these layers were in the long dimension. The reason for changing the grain direction in these layers is that this leads to a card in which there is a much lower risk of cracking of the printed layers. Also, a generally similar degree of resistance to flexure in all directions is achieved. These improvements lead to a longer lifetime. If all the laminae were to be laid with the grain in the same direction, then the result would be a "stiff" card in the axis across the grain. This is undesirable since, from a bending/torsion viewpoint, it is preferred that the card is equally flexible in all directions relative to the "stress reduction" members of the IC Module (to be described).

In the case of plastics layers 1-7 formed by rolling and/or calendering, the "grain" is considered to extend in the long direction of the forming process, ie. the direction of movement of the plastics through the forming apparatus. Typically, this is the predominant direction of shrinkage when the plastics is subjected to heat.

Embedded within the card is an IC module 10 (Figure 2) consisting of a chip 11 defining a single chip microprocessor such as the Hitachi 65901 mounted to a chip carrier 12 formed by a layer of copper 12A on a polyimide layer 12B such as Kapton to define a carrier assembly. The chip carrier 12 is received in an aperture 8 of the layer 4. As will be explained in more detail below, a pair of star shaped stress reduction members 15, 16 are embedded in apertures 14, 9 respectively of the layers 3, 5 in alignment with the chip 11.

As will be explained in more detail below, contacts on the chip 11 are coupled via conductors of the copper layer 12A on the chip carrier 12 with contact members 21 which protrude through the layers 1-3 to allow physical contact with a card reader.

In the finished card, the layers 1, 7 are transparent to allow the printing on layers 2, 6 to be read by the user.

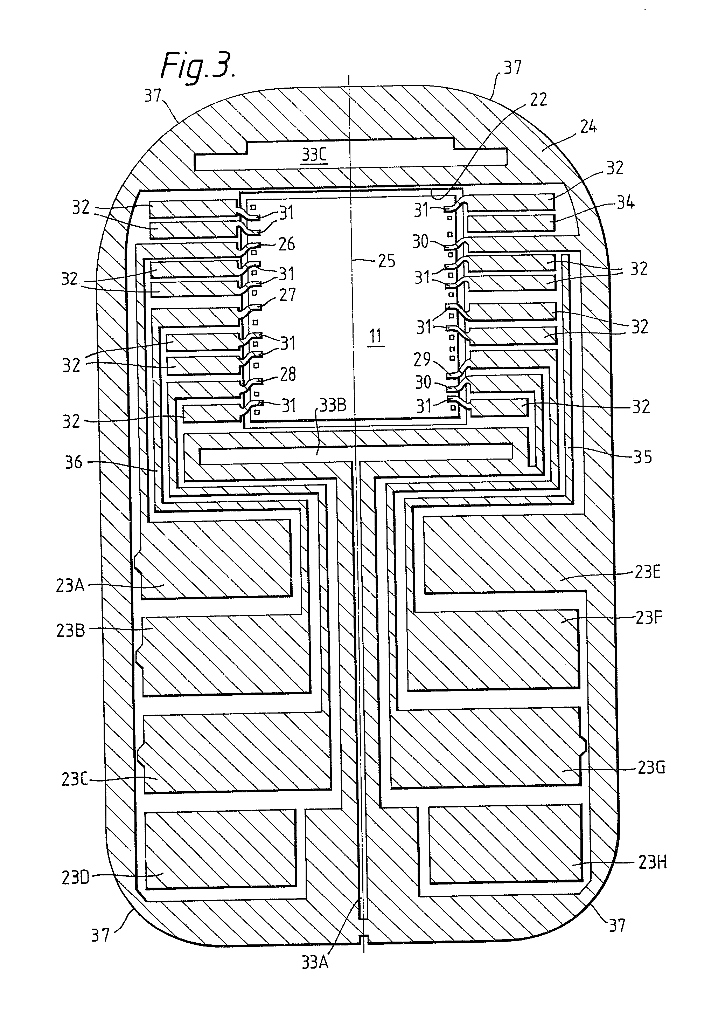

The module shown in Figure 2 is constructed as a separate unit which is then laminated with the layers 1-7. The chip carrier 12 is cut from a Kapton (polyimide) substrate 12B (thickness 75$\mu$m) on which is provided the layer 12A of copper foil (thickness 35$\mu$m) adhered by an epoxy to the Kapton layer 12B. The copper is etched to provide a conductor pattern shown in more detail in Figure 3. In addition the Kapton is punched to provide an aperture 22 in which the chip 11 is received.

It will be seen in Figure 3 that the conductor pattern defines eight contact pads 23A-23H to which the contact members 21 are individually bonded. In addition, the conductor pattern has an outer ground plane 24 extending around the pattern. It should be noted that the contact pads 23A-23H are substantially symmetrically arranged about a line of symmetry 25.

The contact pad 23A is connected with a functional contact 26 of the chip 11; the contact pad 23B is connected to a functional contact 27 of the chip; the contact pad 23C is connected to a functional contact 28 of the chip, and the contact pad 23G is connected to a functional contact 29 of the chip 11. Two functional contacts 30 are connected to the ground plane 24 as is the contact pad 23E. Contact pads 23D, 23F and 23H are isolated.

In addition, a number of non-functional contacts 31 of the chip 11 are connected to respective, short conductors 32 of the conductor pattern such that the arrangement of the conductor pattern adjacent to the chip 11 is substantially symmetrical about the line of symmetry 25. In addition, an isolated conductor 34 is provided to complete the symmetrical arrangement.

In this case, it will be seen that the conductor pattern is bonded to ten contacts of the chip 11 on the left hand side of Figure 3 and nine contacts on the right hand side. This small difference in the number of bonded contact positions is acceptable and the term "substantially symmetrical" should be interpreted accordingly. This substantially symmetrical arrangement of contacts connected to conductors allows the chip 11 to be securely supported in the aperture 22 of the carrier 12 and reduces the risk of undue twisting of the chip 11 within the aperture 22, whilst allowing some freedom of movement of the chip relative to the chip carrier 12. This freedom of movement is necessary to prevent damage to the chip and its connections during manufacture of the IC module 10, during lamination of the IC card, during subsequent use of the IC card. Undue twisting of the chip 11, in the aperture 22, relative to the chip carrier 12 could result in excessive stresses at the IC connections.

The remainder of the conductor pattern is also substantially symmetrical about the line of symmetry 25. In this connection, it should be noted for example that although the contact pad 23F is not connected to the chip 11, a conductor line 35 extends from the contact pad 23F to a position adjacent the chip 11 in a similar way to a conductor line 36 which extends from the contact pad 23B to the contact 27. This assists in overcoming the natural tendancy of the copper layer 12A to distort, which can otherwise weaken the bonds between the conductors and chip contacts before lamination, during lamination, and to some extent after lamination.

In addition, the copper pattern 12A is split at 33A, 33B, 33C to reduce its rigidity, so that the chip carrier 12 will more readily flex when card flexure occurs. The copper pattern is split at 33A along the line of symmetry 25, copper is etched away from a section 33B orthogonal to and communicating with the section 33A, copper is also etched away from a section 33C.

The corners 37 of the carrier 12 are rounded to help to reduce stress concentrations in the card layers at the corners of the carrier.

In constructing the module, the first step is to form the conductor pattern described above. The next step is to bond the contact members 21 to the contact pads 23A-23H.

Following this step, the IC chip 11 is located in the aperture 22 and the chip contacts are bonded to the inner ends of the conductors which overlie the aperture 22, as shown in Figure 3 and as previously described. The method chosen is Tape Automated Bonding (TAB). TAB is preferred to wire bonding since (relative to wire bonding) it provides higher bond strength, greater reliability, improved mechanical construction, and a thinner package.

TAB requires that the IC chip 11 should have its contacts "bumped" to a specified height and consistency to allow for the inner lead bonding of the chip to the carrier. The bumping normally comprises the deposition of gold onto the aluminium contacts of the chip.

After the bonding operation, a resin (polyurethane) coating 50 (Figure 4) is applied to the surface of the IC chip 11 and the inner lead bonds so as to provide for mechanical and optical protection for the chip contact/conductor bonds prior to lamination. This coating 50 is known as the "glob top".

The two star shaped members 15, 16 are then bonded to the chip carrier 12. These members 15,16 are metal and are consequently stiffer than the plastics layers 1-7. The members 15, 16 locally stiffen the card body around the chip 11, they provide a strengthening reinforcement to protect the contact/conductor bonds. The members 15, 16 are stress reduction members reducing the mechanical stresses to which the contact/conductor bonds are subject during card lamination and during card use. To avoid abrupt changes in the card stress conditions, introduced by the members, at the boundaries of the members with the card laminae a "star" shape is adopted as shown in Figure 2. The star profile provides a gradual increase in stiffness from the outer boundary of legs 40 of the star to a central section 41 indicated by a dotted line.

It should be noted that the "stiffness" of a circular plate varies inversely as the square of the diameter and directly as the cube of the thickness.

The members 15, 16 are mounted above and below the chip 11 and it is considered advantageous not to bond the members to the laminate in order to allow relative movement between the members and the laminate during flexing and twisting of the card.

The members 15, 16 are affixed to the chip carrier 12 via respective flexible double-sided adhesive tapes 51, 52 although other forms of flexible bonding could be used. However, it is important that the method used to bond the upper member 15 to the chip carrier 12 is electrically insulating since the upper member 15 contacts the conductor pattern.

In this example the upper member 15 is made of hard-rolled brass and has a thickness of about 50μm. The lower member 16 is made of hard-rolled brass with a thickness of about 150μm. The thicker lower member 16 enables an air pocket to be provided around the chip 11 by providing a machined recess 53 (Figure 4) to accommodate that portion of the chip 11 which protrudes below the chip carrier 12.

In other examples, other metals such as stainless steel or coppernickel alloy could be used. In addition the upper member 15 could be in a different metal such as stainless steel to the lower member 16 such as brass. Furthermore, the lower member 16 could be formed similar to the upper member 15 with a thickness of about 50μm and without a recess. In this case the resulting space would be filled with a suitable material such as a double sided adhesive tape, which will allow a cavity to be formed to accommodate that portion of the chip 11 that protrudes below the chip carrier 12 and, furthermore which will allow a flexible bonding to the lower member 16 and to the chip carrier 12.

It has been found that it is not necessary to cut an aperture in the double-sided adhesive tape 51 used to attach the upper member 15 to accommodate the glob-top 50 since the tape is sufficiently flexible to allow the glob-top to be impressed into it (during card lamination).

It should be noted that in the case of the members 15, 16 both being of the same thickness of about 50μm then the typical thickness of each double-sided tape is 85μm for the upper member and 200 μm for the lower member 16. It should be noted that in the case of the upper member 15 having a thickness of about 50μm and the lower member 16 having a thickness of about 150μm then the typical thickness of each double-sided tape is 85μm for both members15, 16.

It will be noted that each member 15, 16 has an odd number of legs 40 (in this example 7) so as to avoid an "axis of stress" being set up in the card laminae and extending through the star centre. This also allows the legs 40 of the upper member 15 to fit conveniently with the contact members 21.

In this example, the diameter of the central section 41 of the upper member 15 is made to correspond to the diagonal dimension of the chip 11, for example 9mm and the outer boundary (defined by the tips of the legs 40) is 13mm to suit the width of the chip carrier 12 and the contact arrangement. For the lower member 16, the central section is made to correspond to the width of the chip carrier 12 and has a diameter of about 15mm and the outer boundary is made to suit the card boundaries with a diameter of about 21mms.. Preferably, the two members 15, 16 are positioned so that the legs 40 do not align, in order to avoid possible stress concentrations.

In most examples, each member 15, 16 will have a constant thickness but in some cases, some tapering could be provided from the inner annulus towards the legs.

The completed module 10 (Figure 2) is then assembled with the PVC card layers 1-7 within which it is to be laminated. The module is located in a punched aperture 8 in the layer 4 which is shaped to conform to the chip carrier 12. The layer 5 has a punched star-shaped aperture 9 conforming to the lower member 16 while the layer 3 has a punched aperture 14 having a star-shape conforming to the upper stress reduction member 15 and a set of eight punched apertures 21' through which the contact members 21 protrude. In addition, the layers 1, 2 have sets of eight punched apertures, one set of which is shown at 13 through which the contact members 21 extend so as to finish substantially flush with the outer surface of the layer 1.

It will be noted that the orientation of the chip carrier 12 is transverse to the long axis of the layers 1-7. This orientation is best, from the point of view of card bending/torsion.

The assembled pre-laminate including the module is then laminated using conventional lamination machinery (heated presses). The normal (plastic identification card) lamination technique is to place the lamina build-up into a pre-heated press and immediately apply full pressure (compressing the lamina sheets together). In an alternative method, the applied pressure is gradually increased. For example, the press may be pre-heated to 140°C and then pressure applied in steps. Finally, the laminate is cooled for about 10 minutes with the pressure maintained at its highest value.

It is important that during the lamination process the chip 11 and the contact/conductor bonds are not subjected to undue compressive stresses due to bending. The silicon material has a compressive breaking stress of 15000 lb per square inch but the tensile breaking stress is only 3000 lb per square inch.

The members 15, 16 provide the major resistance to undesirable tensile stresses within the chip 11 and the contact/conductor bonds but in addition use is made of the "pocketing" of the chip in an air filled cavity as defined by the machined recess 53 in the lower member 16. This is because the surrounding gas (air) is readily compressible and will therefore transport the compression forces during laminating uniformly to the chip without subjecting the chip 11 to undesirable tensile stresses due to bending.

The preferred stress reduction members 15, 16 are made from metals, such as hard-rolled stainless steel and brass which exhibit a grain. This causes the members to take up a natural curvature, due to the hard rolling method, which is "memorised" even when the member is flattened. To optimise performance, therefore, it is preferred if this grain extends across the card, that is parallel with the short dimension of the card, while the natural bow or curvature of both members 15, 16 is outwardly of the card. The grain direction of the members 15, 16 is indicated in Figure 2 by arrows 54.

## Claims

1. An integrated circuit card comprising a planar body within which is mounted an IC element (11), the card further comprising a stress reduction member (15,16) positioned between the IC element (11) and one surface of the body, the stress reduction member stiffening the card body only adjacent the IC element so as to reduce stresses to which the IC element is subjected.

2. A card according to claim 1, wherein two stress reduction members (15,16) are provided on opposite sides of the IC element (11).

3. A card according to claim 1 or claim 2, wherein the or each IC element has at least one protruding portion (40) extending laterally into the card body.

4. A card according to claim 3, when dependent on claim 2, wherein the or each protruding portion (40) of one member is angularly offset from each protruding portion of the other member.

5. A card according to claim 3 or claim 4, wherein the or each stress reduction member (15,16) has an odd number of protruding portions (40).

6. A card according to any of the preceding claims, wherein the or each stress reduction member (15,16) has a central portion (41) with an area which covers at least the IC element.

7. A card according to any of the preceding claims, wherein the or each stress reduction member (15,16) has a star shape.

8. A card according to any of the preceding claims, wherein the or each stress reduction member (15,16) is formed from a material which has a "grain" structure, the stress reduction member being arranged such that the grain extends transversely to a long dimension of the card body.

9. A card according to any of the preceding claims, wherein the or each stress reduction member (15,16) is made of metal.

10. A card according to any of the preceding claims, wherein the or each stress reduction member (15,16) has a substantially constant thickness.

11. A card according to any of the preceding claims, wherein the card body is formed as a laminated structure (1-7), and wherein the or each stress reduction member (15,16) is not bonded to the laminated structure.

12. A card according to any of the preceding claims, wherein the IC element (11) is connected to a carrier member (12) to define an IC module (10) which is supported within the card body, and wherein the or each stress reduction member (15,16) is flexibly bonded to the carrier member (12).

# Fig.1.

# Fig.2.

## Fig.3.

# Fig.4.

EP 0 311 434 A2